(19) Europäisches Patentamt

European Patent Office

Office européen des brevets

(11) **EP 0 507 336 B1**

(12) **EUROPÄISCHE PATENTSCHRIFT**

(45) Veröffentlichungstag und Bekanntmachung des Hinweises auf die Patenterteilung:
**08.07.1998 Patentblatt 1998/28**

(51) Int Cl.⁶: $G11C\ 7/00$, $G11C\ 11/409$

(21) Anmeldenummer: **92105811.1**

(22) Anmeldetag: **03.04.1992**

(54) **Dekodierte Ausleseschaltung**

Decoding read circuit

Circuit de lecture décodée

(84) Benannte Vertragsstaaten:
**AT DE FR GB IT NL**

(30) Priorität: **05.04.1991 DE 4111104**

(43) Veröffentlichungstag der Anmeldung:
**07.10.1992 Patentblatt 1992/41**

(73) Patentinhaber: **SIEMENS AKTIENGESELLSCHAFT**
**80333 München (DE)**

(72) Erfinder:
• **Pfeiffer, Roland, Dipl.-Ing.**
**W-8000 München 70 (DE)**
• **Hoffmann, Kurt, Prof. Dr.-Ing.**
**W-8028 Taufkirchen (DE)**

(56) Entgegenhaltungen:
**EP-A- 0 048 464**    **EP-A- 0 171 518**
**US-A- 3 953 839**

Printed by Jouve, 75001 PARIS (FR)

**Beschreibung**

Die Erfindung betrifft eine Schaltungsanordnung zur Infomationsübertragung zwischen internen Bitleitungen und externen Datenleitungen eines dynamischen Halbleiterspeichers.

Dynamische Halbleiterspeicher oder DRAMs enthalten üblicherweise Zellenfelder, in denen die einzelnen Zellen über Wort- und Bitleitungen adressierbar sind. In einem matrixförmigen Aufbau mit I-Transistor-Speicherzellen steuert die adressierte Wort leitung einen Auswahltransistor an, der die entsprechende Speicherkapazität mit der adressierten Bitleitung verbindet. An jeder Bitleitung liegen üblicherweise eine Vielzahl von Speicherzellen. Da die Kapazität der Bitleitung wesentlich größer ist als die einzelne Speicherkapazität, auf die zugegriffen werden soll, erfordert der Lesevorgang einen genügend großen Spannungshub, um eine Bewertung vornehmen zu können. Eine direkte Kopplung der Bitleitungen auf die außerhalb der Zellenfelder liegenden externen Datenleitungen ist deshalb nicht möglich.

Üblicherweise wird die Zellinformation vor dem Auslesen auf die externen Datenleitungen erst durch einen internen Bewerter oder Leseverstärker auf einen ausreichenden Pegel verstärkt. Das verstärkte Zellsignal wird dann über Transfergatter auf die externen Datenleitungen bzw. die Ein- und Ausgabeschaltung ausgegeben. Die Transfergatter selbst werden von einem Bitleitungsdekoder aktiviert. Es ist ohne weiteres klar, dass der Auslesevorgang durch die zunächst erfolgende Verstärkung und die anschließende Übertragung über Transfergatter auf die externen Datenleitungen vergleichsweise viel Zeit kostet.

Aus der US 3,953,839 ist ein Schreib-Lese-Speicher bekannt, bei dem zum Beschreiben und Auslesen der einzelnen Spalten Schaltungen verwendet sind, bei denen Bit- und Datenleitungen und die entsprechenden komplementären Leitungen durch Feldeffekttransistoren miteinander verbunden sind.

Zur Verringerung des Zeitaufwands und zur Beschleunigung des Auslesevorgangs sind spezielle Schaltungen bekannt, beispielsweise die Veröffentlichung M. Aoki et al., "A 60-ns 16-Mbit CMOS DRAM with a Transposed Data-Line Structure", IEEE Journal of Solid-State Circuits, Vol. 23, pp. 1113-1119, October 1988. Die Veröffentlichung beschreibt den Einsatz eines Stromverstärkers als Bindeglied zwischen dem mit 3,3 V arbeitenden Zellenfeld und der mit 5 V betriebenen äußeren Schaltung. Mit der Schaltung kann der Auslesevorgang beschleunigt werden, so daß sich die Zeitverzögerung für den Auslesevorgang von den internen Bitleitungen auf die externen Datenleitungen verringert. Die verbleibende Verzögerungszeit ist allerdings immer noch unbefriedigend.

Der Erfindung liegt die Aufgabe zugrunde, eine verbesserte Möglichkeit zumindest zur Reduzierung der Verzögerungszeiten beim Auslesevorgang von internen Bitleitungen auf externe Datenleitungen bei dynamischen Halbleiterspeichern anzugeben.

Diese Aufgabe wird bei einer Anordnung der eingangs genannten Art durch die kennzeichnenden Merkmale des Patentanspruchs 1 gelöst.

Die Erfindung hat den Vorteil, daß der Auslesevorgang derartig beschleunigt wird, daß das Auslesen der Daten auf die externen Eitleitungen gleichzeitig mit dem Bewertungsvorgang erfolgen kann. Auf diese Weise läßt sich das Auslesen eines Datums vom Ansprechen einer adressierten Wertleitung bis zum Auslesen auf die externe Bitleitung auf wenige ns reduzieren. Weiterhin bietet die Erfindung den Vorteil, daß sie sich sowohl für eine CMOS-Ausleseschaltung als auch für eine BICMOS-Ausleseschaltung eignet. Bei der möglichen Verwendung bipolarer Transistoren kann eine gemeinsame Wanne für alle Transistoren gewählt werden und die kapazitive Belastung ist durch die geringe Basis-Emitter-Kapazität der Bipolartransistoren sehr gering. Auf diese Weise kann eine weitere Beschleunigung des Ausleseverfahrens erreicht werden, da die Transistoren schneller auf Spannungsänderungen ansprechen und die hohe Stromergiebigkeit ein schnelleres Umladen der Lastkapazitäten ermöglicht.

Ausgestaltungen der Erfindung sind in Unteransprüchen gekennzeichnet.

Die Erfindung wird nachfolgend anhand von in den Figuren der Zeichnung dargestellten Ausführungsbeispielen näher erläutert. Gleiche Elemente sind mit gleichen Bezugszeichen versehen. Es zeigt:

Figur 1      eine erfindungsgemäße CMOS-Ausleseschaltung und

Figur 2      eine erfindungsgemäße BICMOS-Ausleseschaltung.

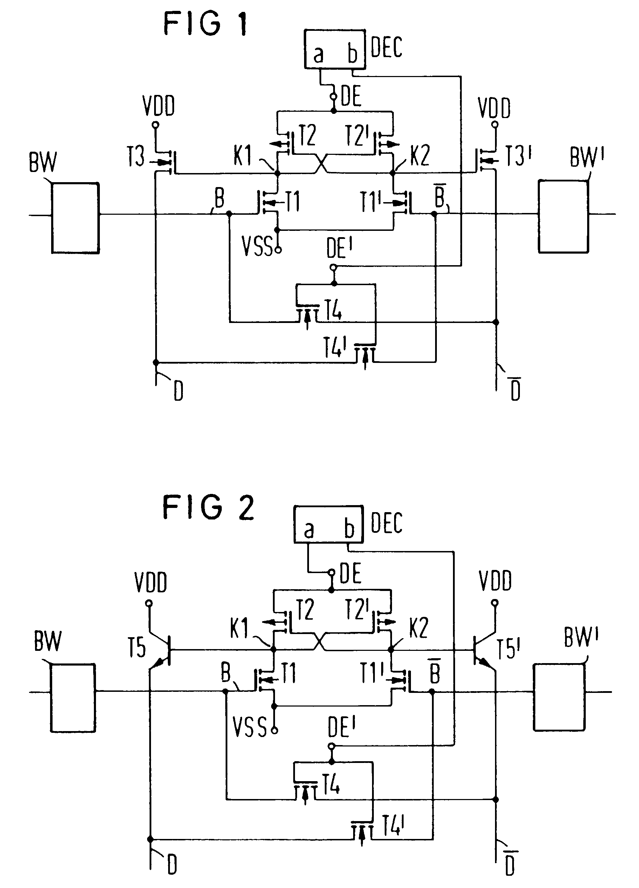

Gemäß Figur 1 enthält die Schaltung die n-Kanal-Transistoren T1 und T1', an deren Gates die Bitleitungen B bzw. $\bar{B}$ geführt sind. Jeder der beiden Transistoren ist an seinem Sourceanschluß mit einem Bezugspotential VSS und an seinem Drainanschluß mit einem Koppelpunkt K1 bzw. K2 verbunden. Ebenfalls an den Koppelpunkten K1 und K2 sind zwei kreuzgekoppelte p-Kanal-Transistoren T2 und T2' angeschlossen. Das Gate von T2 liegt dabei am Koppelpunkt K2 und das Gate von T2' am Koppelpunkt K1. An K1 ist ebenfalls ein Anschluß des Ausgangskreises von T2 und entsprechend an K2 ein Anschluß des Ausgangskreises von T2' angeschlossen. Die anderen Anschlüsse der Ausgangskreise von T2 und T2' sind miteinander und mit einer Klemme DE verbunden, die zum Empfang eines Dekodersignals mit dem Dekoder DEC verbunden ist.

Der Koppelpunkt K1 ist weiterhin mit dem Gate eines Transistors T3 verbunden, dessen Ausgangsanschlüsse einerseits an einem Versorgungspotential VDD und andererseits an einer Datenleitung D angeschlossen sind. Entsprechend ist der Koppelpunkt K2 mit dem Gate eines Transistors T3' verbunden, dessen Ausgangsanschlüsse mit dem Versorgungspotential VDD und der komplementären Datenleitung $\bar{D}$ verbunden sind. Zwischen der Bitleitung B und der komplementären Datenleitung $\bar{D}$ liegt der Ausgangskreis eines Transistors T4, während zwischen der komplementären Bitleitung $\bar{B}$ und der Datenleitung D der Ausgangskreis eines Transistors T4' angeschlossen ist. Die Gates der beiden Transistoren T4 und T4' sind miteinander und mit einer Klemme DE' verbunden, die zum Empfang eines zweiten Dekodersignals mit dem Dekoder DEC verbunden ist.

An den Bitleitungen E und $\bar{B}$ liegen Bewerter bzw. Leseverstärker BW bzw. BW', die entsprechend einer an den Dekoder DEC angelegten CAS-Adresse aktivierbar sind. Bei einem Lesevorgang werden die Bewerter BW bzw. BW' an den Bitleitungen entsprechend der Spaltenadresse CAS aktiviert und gleichzeitig erzeugt der Dekoder ein Signal, das über den Eingang DE der Ausleseschaltung die Transistoren T2 und T2' aktiviert. Das an der Klemme DE' liegende zweite Dekodersignal sperrt bei einem Lesevorgang die Transistoren T4 und T4'.

Bei der so getroffenen Schaltungsanordnung sinkt für ein logisches H-Lesesignal auf der Bitleitung B die Spannung am Knoten K1, während entsprechend umgekehrt ein logisches L-Lesesignal auf der komplementären Bitleitung $\bar{B}$ zu einem Steigen der Spannung am Knoten K2 führt. Für eine schnelle Einstellung dieser Verhältnisse sorgt insbesondere die Kreuzkopplung der Transistoren T2 und T2'. Bei einem niedrigen Potential am Knoten K1 und einem hohen Potential am Knoten K2 werden die Transistoren T3 bzw. T3' so angesteuert, daß Transistor T3 sperrt und Transistor T3' leitet. Damit wird die externe Datenleitung D auf niedriges logisches Potential L und die komplementäre Datenleitung $\bar{D}$ auf hohes logisches Potential H entsprechend dem Versorgungspotential VDD des Transistors T3' gesetzt.

Völlig entsprechend arbeitet die Schaltung, wenn auf der komplementären Bitleitung B' ein logisch hohes Bitleitungssignal und auf der Bitleitung B ein logisch niedriges Bitleitungssignal liegt. Die Datenleitung D nimmt dann logisch hohes Potential VDD und die Datenleitung $\bar{D}$ das komplementäre logisch niedrige Potential an.

Im Gegensatz zu bekannten Schaltungsanordnungen mit der Bewertung der Bitleitungen und anschließendem Auslesen kann bei der erfindungsgemäßen Schaltung gemäß Figur 1 der Bewertungsvorgang und das Auslesen auf die externen Bitleitungen gleichzeitig erfolgen. Dies wird deswegen möglich, weil die komplementären Ausgangssignale der Bewerter BW bzw. BW' der Bitleitungen B bzw. B die Transistoren T1 und T1' stromlos ansteuern und die mit Hilfe der durch die Mitkopplung der Transistoren T2 und T2' verstärkten Bitleitungssignale an die als Sourcefolger arbeitenden Transistoren T3 und T3' weitergeleitet werden. Auf diese Weise läßt sich mit der erfindungsgemäßen Schaltung das Auslesen eines Datums vom Ansprechen einer adressierten Wortleitung bis zur Ausgabe an die externen Bitleitungen D bzw. $\bar{D}$ auf etwa 4 ns reduzieren.

Für das Rückschreiben der Daten von den externen Datenleitungen D und $\bar{D}$ über die Bitleitungen B und $\bar{B}$ in die Zellen werden die Transistoren T2 und T2' mit Hilfe des an der Klemme DE angeschlossenen Dekoders deaktiviert, während andererseits ein zweites Dekodersignal, das über die Klemme DE' geführt wird, die Transistoren T4 und T4' aktiviert. Die vom Dekoder erzeugten Aktiviersignale für die Transistoren T2 und T2' und die Steuersignale für die Transistoren T4 und T4' überlappen sich im wesentlichen nicht. Da mit dem zweiten Dekodersignal sowohl der Transistor T4 als auch der Transistor T4' durchgeschaltet werden, wird an die Bitleitung B das logische Potential der Datenleitung $\bar{D}$ und an die Bitleitung $\bar{B}$ das logische Potential der Datenleitung D angelegt. Wenn das interne Zellenfeld nur mit einer Versorgungsspannung von 3,3 V betrieben wird, genügt es, die Transistoren T4 und T4' mit der externen Versorgungsspannung VDD von 5 V durchzuschalten.

Bei der erfindungsgemäßen Schaltung wird die Bitleitungskapazität nur um die Gatekapazität des Transistors T1 bzw. T1' erhöht. Das Verhältnis von Speicherzellenkapazität zu Bitleitungskapazität verringert sich deshalb nur unwesentlich. Da das Rückschreiben über die Transistoren T4 und T4' erfolgt, ist kein zusätzliches externes Bitleitungspaar erforderlich.

Das Ausführungsbeispiel gemäß Figur 2 unterscheidet sich von dem Ausführungsbeispiel gemäß Figur 1 dadurch, daß statt der n-Kanal-MOS-Verstärkertransistoren T3 und T3' bipolare Transistoren T5 und T5' verwendet werden. Die Funktion der Schaltunc entspricht der Funktion gemäß dem Ausführungsbeispiel der Figur 1. Die wesentlichen Vorteile der Verwendung von bipolaren Transistoren T5 und T5' bestehen darin, daß für alle Transistoren bei der Realisierung auf dem Chip eine gemeinsame Wanne gewählt werden kann und nur die geringe Basis-Emitter-Kapazität der Bipclartransistoren wirksam ist. Dadurch wird eine weitere Beschleunigung des Ausleseverfahrens erreicht, da die Transistoren schneller auf die Spannungsänderungen ansprechen und die hohe Stromergiebigkeit der bipolaren Transistoren ein schnelleres Umladen der Lastkapazitäten ermöglicht.

**Patentansprüche**

1. Schaltungsanordnung zur Informationsübertragung zwischen den Zellenfeldern zugeordneten, internen Bitleitungen (B, $\bar{B}$) und außerhalb der Zellenfelder liegenden, externen Datenleitungen (D, $\bar{D}$) eines dynamischen Halbleiterspeichers mit einem ersten Transistorpaar (T1, T1'), einem zweiten Transistorpaar (T3, T3') und einem dritten Transistorpaar (T2, T2'), wobei die Bitleitungen (B, $\bar{B}$) mit den Gateanschlüssen des ersten Transitorpaares (T1, T1') und die Ausgänge des ersten Transistorpaares (T1, T1') zum einen über das zweite Transistorpaar (T3, T3') mit den Datenleitungen (D, $\bar{\text{D}}$) verbunden sind, dadurch **gekennzeichnet,**
dass die Ausgänge des ersten Transistorpaares (T1, T1') zum anderen über das dritte Transistorpaar (T2, T2') mit einem Bitleitungsdecoder (DEC) verbunden sind, wobei die Transistoren des dritten Transistorpaares (T2, T2') miteinander kreuzgekoppelt verschaltet sind.

2. Anordnung nach Anspruch 1, **dadurch gekennzeichnet,**
   daß die Schaltungsanordnung ein viertes Transistorpaar (T4, T4') umfasst, wobei die Transistoren des vierten Transistorpaares (T4, T4') kreuzweise zwischen der Datenleitung (D, $\bar{\text{D}}$) und der Bitleitung ($\bar{\text{B}}$, B) liegen und ihre Steuereingänge mit dem Bitleitungsdecoder (DEC) verbunden sind.

3. Anordnung nach Anspruch 1 oder 2, **dadurch gekennzeichnet,**
   daß die zweiten Transistoren (T2, T2') MOS-Transistoren vom p-Kanal-Typ sind.

4. Anordnung nach einem der Ansprüche 1 bis 3, **dadurch gekennzeichnet,**
   daß die dritten Transistoren (T3, T3') MOS-Transistoren vom n-Kanal-Typ sind.

5. Anordnung nach einem der Ansprüche 1 bis 3, **dadurch gekennzeichnet,**
   daß die dritten Transistoren (T3, T3') npn-Bipolartransistoren sind.

6. Anordnung nach einem der Ansprüche 1 bis 5, **dadurch gekennzeichnet,**
   daß die zweiten Transistoren (T2, T2') durch den Bitleitungsdekoder (DEC) aktivierbar sind.

7. Anordnung nach einem der Ansprüche 2 bis 6, **dadurch gekennzeichnet,**
   daß vom Bitleitungsdekoder (DEC) erzeugte Aktiviersignale für cie zweiten Transistoren (T2, T2') und Steuersignale für die vierten Transistoren (T4, T4') im wesentlich nicht überlappend sind.

## Claims

1. Circuit arrangement for information transfer between internal bit lines (B, $\bar{\text{B}}$), which are assigned to the cell arrays, and external data lines (D, $\bar{\text{D}}$), which lie outside the cell arrays, of a dynamic semiconductor memory having a first transistor pair (T1, T1'), a second transistor pair (T3, T3') and a third transistor pair (T2, T2'), the bit lines (B, $\bar{\text{B}}$) being connected to the gate terminals of the first transistor pair (T1, T1'), and the outputs of the first transistor pair (T1, T1') being connected, on the one hand, via the second transistor pair (T3, T3') to the data lines (D, $\bar{\text{D}}$), characterized in that the outputs of the first transistor pair (T1, T1') are connected, on the other hand, via the third transistor pair (T2, T2') to a bit line decoder (DEC), the transistors of the third transistor pair (T2, T2') being connected up to one another in a cross-coupled manner.

2. Arrangement according to Claim 1, characterized in that the circuit arrangement comprises a fourth transistor pair (T4, T4'), the transistors of the fourth transistor pair (T4, T4') lying crosswise between the data line (D, $\bar{\text{D}}$) and the bit line ($\bar{\text{B}}$, B), and their control inputs being connected to the bit line decoder (DEC).

3. Arrangement according to Claim 1 or 2, characterized in that the second transistors (T2, T2') are MOS transistors of the p-channel type.

4. Arrangement according to one of Claims 1 to 3, characterized in that the third transistors (T3, T3') are MOS transistors of the n-channel type.

5. Arrangement according to one of Claims 1 to 3, characterized in that the third transistors (T3, T3') are npn bipolar transistors.

6. Arrangement according to one of Claims 1 to 5, characterized in that the second transistors (T2, T2') can be activated by the bit line decoder (DEC).

7. Arrangement according to one of Claims 2 to 6, characterized in that activation signals for the second transistors (T2, T2') and control signals for the fourth transistors (T4, T4'), which signals are generated by the bit line decoder (DEC), essentially do not overlap.

## Revendications

1. Montage pour la transmission d'information entre des lignes (B, $\bar{\text{B}}$) internes de transmission de bits associées aux zones de cellules et des lignes (D, $\bar{\text{D}}$) externes de transmission de données, se trouvant à l'extérieur des zones de cellules, d'une mémoire dynamique à semi-conducteurs comportant un premier couple (T1, T1') de transistors, un deuxième couple (T3, T3') de transistors et un troisième couple (T2, T2') de transistors, les lignes (B, $\bar{\text{B}}$) de transmission de bits étant reliées aux bornes de grilles du premier couple (T1, Tl') de transistors et les sorties du premier couple (T1, Tl') de transistors étant reliées, d'une part, par l'intermédiaire du deuxième couple (T3, T3') de transistors aux lignes (D, $\bar{\text{D}}$) de transmission de données, caractérisé en ce que les sorties du premier couple (T1, T1') de transistors sont reliées, d'autre part, par l'intermédiaire du troisième couple (T2, T2') de transistors à un décodeur (DEC) de lignes de transmission de bits, les transistors du troisième couple (T2, T2') de transistors étant couplés en croix.

2. Dispositif suivant la revendication 1, caractérisé en ce que le montage comprend un quatrième couple (T4, T4') de transistors, les transistors du quatrième couple (T4, T4') de transistors se trouvant en croix entre la ligne (D, $\overline{D}$) de transmission de données et la ligne ($\overline{B}$, B) de transmission de bits et leurs entrées de commande étant reliées au décodeur (DEC) de lignes de transmission de bits.

3. Dispositif suivant la revendication 1 ou 2, caractérisé en ce que les deux transistors (T2, T2') sont des transistors MOS du type à canal p.

4. Dispositif suivant l'une des revendications 1 à 3, caractérisé en ce que les troisièmes transistors (T3, T3') sont des transistors MOS du type à canal n.

5. Dispositif suivant l'une des revendications 1 à 3, caractérisé en ce que les troisièmes transistors (T3, T3') sont des transistors bipolaires du type npn.

6. Dispositif suivant l'une des revendications 1 à 5, caractérisé en ce que les deuxièmes transistors (T2, T2') peuvent être activés par le décodeur (DEC) de lignes de transmission de bits.

7. Dispositif suivant l'une des revendications 2 à 6, caractérisé en ce que des signaux d'activation des deuxièmes transistors (T2, T2') produits par le décodeur (DEC) de transmission de bits et des signaux de commande des quatrièmes transistors (T4, T4') ne sont sensiblement pas en chevauchement.

FIG 1

FIG 2